# EUROPEAN PATENT APPLICATION

(11) **EP 4 542 431 A1**
(43) Date of publication of application: **23.04.2025**
(21) Application number: 23853804.5
(22) Date of filing: 18.01.2023
(51) Int. Cl.: G06F 30/18

(54) **GRID CODING METHOD, APPARATUS, AND DEVICE**

(30) Priority: 17.08.2022 CN 202210987474
(71) Applicant: Huawei Technologies Co., Ltd., Shenzhen, Guangdong 518129 (CN)
(72) Inventor: ZHOU, Yinsheng, Shenzhen, Guangdong 518129 (CN); HUANG, Qian, Shenzhen, Guangdong 518129 (CN); WANG, Hao, Shenzhen, Guangdong 518129 (CN); ZHANG, Jun, Shenzhen, Guangdong 518129 (CN); SHEN, Zhongming, Shenzhen, Guangdong 518129 (CN); XU, Liyan, Beijing 100080 (CN); YU, Hongbin, Beijing 100080 (CN); LI, Yihang, Beijing 100080 (CN)
(74) Representative: Pfenning, Meinig & Partner mbB
(86) International application number: PCT/CN2023/072838
(87) International publication number: WO 2024/036883

(57) **Abstract**

A grid coding method is provided, including: obtaining at least one traffic autonomous zone (TAZ) grid; and coding each TAZ grid, to obtain a grid code of each TAZ grid. Each grid code includes a level code, a key code, a bounding code, a compression code, a boundary chaincode, and an attribute code. The level code represents a level of the TAZ grid in GeoSOT. The key code represents a subgrid that is inside the TAZ grid and that includes a centroid obtained based on a minimum bounding rectangle of the TAZ grid. The bounding code represents the minimum bounding rectangle of the TAZ grid. The compression code represents a compression level set by a user for an original chaincode. The boundary chaincode represents a boundary obtained by optimizing a boundary of the TAZ grid. The attribute code represents a service scenario of an area in which the TAZ grid is located. **In** this way, a unique spatial flag can be established for each TAZ grid, so that data of different systems can be mapped to the TAZ grid, thereby reducing difficulty in cross-system data exchange.

## Description

This application claims priority to Chinese Patent Application No. 202210987474.4, filed with the China National Intellectual Property Administration on August 17, 2022 and entitled "GRID CODING METHOD AND APPARATUS, AND DEVICE", which is incorporated herein by reference in its entirety.

### TECHNICAL FIELD

This application relates to the field of artificial intelligence (artificial intelligence, AI) technologies, and in particular, to a grid coding method and apparatus, and a device.

### BACKGROUND

During network planning and optimization, an operator needs to manually divide a city into several grids according to a specific rule. The grids are generally spatial places divided based on static data such as a road network, and social functions of the places are identified, for example, a school, a hospital, a government, and a company. A grid-based operation and management method can quickly focus on a problem area and implement precise planning and optimization, to increase revenue and reduce costs. Currently, the operator generally divides the city into several grid units according to a specific rule by using a traffic autonomous zone (traffic autonomous zone, TAZ), and performs grid-based management. The TAZ is a spatial division method based on interaction intensity between a road network, a point of interest (point of interest, POI), and spatial places. A spatial place obtained through division based on the method can better correspond to a same type of people, and patterns of crowd activities in each place are highly consistent. Therefore, more proper functional zoning can be implemented. However, because a grid obtained through division based on the TAZ is usually an irregular graph, it is difficult to determine a spatial flag of the grid after the division. Consequently, it is difficult to map data between different systems (such as an operations support system and a business support system) to the grid obtained through division based on the TAZ, making it difficult to implement cross-system data exchange.

### SUMMARY

This application provides a grid coding method and apparatus, a device, a computer storage medium, and a computer product, to establish a unique spatial flag for each TAZ grid, so that data of different systems can be mapped to the TAZ grid, thereby reducing difficulty in cross-system data exchange.

According to a first aspect, this application provides a grid coding method, including: obtaining at least one traffic autonomous zone (TAZ) grid; and coding each TAZ grid, to obtain a grid code of each TAZ grid. Each grid code includes a level code, a key code, a bounding code, a compression code, a boundary chaincode, and an attribute code. The level code represents a level of the TAZ grid in geographical coordinate subdividing grid with one-dimensional integer coding on 2n-tree (GeoSOT). The key code represents a subgrid that is inside the TAZ grid and that includes a centroid obtained based on a minimum bounding rectangle of the TAZ grid. The bounding code represents the minimum bounding rectangle of the TAZ grid. The compression code represents a compression level set by a user for an original chaincode, and the original chaincode is a code of a grid chain formed by all subgrids outside the TAZ grid. The boundary chaincode represents a boundary obtained by optimizing a boundary of the TAZ grid. The attribute code represents a service scenario of an area in which the TAZ grid is located.

In this way, after the TAZ grid is obtained, each TAZ grid may be coded, to obtain a unique spatial flag of the TAZ grid, so that data of different systems can be mapped to the TAZ grid, thereby reducing difficulty in cross-system data exchange.

In a possible implementation, the level code is the same as a value of the level of the TAZ grid in the GeoSOT. In this way, a mapping relationship between the TAZ grid and a grid in the GeoSOT can be established by using the level code.

In a possible implementation, the key code is a grid code of a first subgrid in the GeoSOT, and the first subgrid is a subgrid that is inside the TAZ grid and that includes the centroid obtained based on the minimum bounding rectangle of the TAZ grid. In this way, a location of the centroid of the TAZ grid in the GeoSOT can be obtained by querying the GeoSOT by using the key code.

In a possible implementation, the bounding code is obtained based on locations of two endpoints of any diagonal of the bounding rectangle. In this way, the location of the TAZ grid in the GeoSOT can be obtained by querying the GeoSOT by using the bounding code.

In a possible implementation, the boundary chaincode is obtained based on the compression code and the original chaincode. For example, the compression code may be a value preset by the user. In this way, the boundary of the TAZ grid can be obtained by querying the GeoSOT by using the boundary chaincode.

In a possible implementation, obtaining the boundary chaincode based on the compression code and the original chaincode specifically includes: extracting, with an objective of maintaining a shape of the TAZ grid, second subgrids having a quantity the same as a value of the compression code from all the subgrids outside the TAZ grid, where at least one of the second subgrids is in a first direction of the centroid of the bounding rectangle; determining a relative location relationship between the second subgrids based on the original chaincode; and obtaining the boundary chaincode based on the relative location relationship between the second subgrids. In this way, the original chaincode is compressed by using the compression code, to reduce subsequent query workload and improve efficiency.

In a possible implementation, the attribute code is obtained by querying a preset mapping relationship between categories and category code numbers based on a category of the area in which the TAZ grid is located. The attribute code is a category code number associated with the category of the area in which the TAZ grid is located. In this way, the service scenario of the area in which the TAZ grid is located can be obtained by using the attribute code.

In a possible implementation, each grid code further includes a service code. The service code may represent target data in an area indicated by the TAZ grid identified by the grid code. In this way, data in the area indicated by the TAZ grid can be mapped to the TAZ grid.

In a possible implementation, there are a plurality of pieces of target data, and different pieces of target data are from different platforms. In this way, data generated by different platforms in the area indicated by the TAZ grid can be mapped to the same TAZ grid, implementing cross-system data exchange. For example, the different platforms may include an O domain system, a B domain system, an S domain system, and the like.

According to a second aspect, this application provides a grid coding apparatus, including: an obtaining module and a processing module. The obtaining module is configured to obtain at least one traffic autonomous zone (TAZ) grid. The processing module is configured to code each TAZ grid, to obtain a grid code of each TAZ grid, where each grid code includes a level code, a key code, a bounding code, a compression code, a boundary chaincode, and an attribute code. The level code represents a level of the TAZ grid in geographical coordinate subdividing grid with one-dimensional integer coding on 2n-tree (GeoSOT). The key code represents a subgrid that is inside the TAZ grid and that includes a centroid obtained based on a minimum bounding rectangle of the TAZ grid. The bounding code represents the minimum bounding rectangle of the TAZ grid. The compression code represents a compression level set by a user for an original chaincode, and the original chaincode is a code of a grid chain formed by all subgrids outside the TAZ grid. The boundary chaincode represents a boundary obtained by optimizing a boundary of the TAZ grid. The attribute code represents a service scenario of an area in which the TAZ grid is located.

In a possible implementation, the level code is the same as a value of the level of the TAZ grid in the GeoSOT.

In a possible implementation, the key code is a grid code of a first subgrid in the GeoSOT, and the first subgrid is a subgrid that is inside the TAZ grid and that includes the centroid obtained based on the minimum bounding rectangle of the TAZ grid.

In a possible implementation, the bounding code is obtained based on locations of two endpoints of any diagonal of the bounding rectangle.

In a possible implementation, the boundary chaincode is obtained based on the compression code and the original chaincode.

Further, the processing module is specifically configured to: extract, with an objective of maintaining a shape of the TAZ grid, second subgrids having a quantity the same as a value of the compression code from all the subgrids outside the TAZ grid, where at least one of the second subgrids is in a first direction of the centroid of the bounding rectangle; determine a relative location relationship between the second subgrids based on the original chaincode; and obtain the boundary chaincode based on the relative location relationship between the second subgrids.

In a possible implementation, the attribute code is obtained by querying a preset mapping relationship between categories and category code numbers based on a category of the area in which the TAZ grid is located. The attribute code is a category code number associated with the category of the area in which the TAZ grid is located.

In a possible implementation, each grid code further includes a service code. The service code represents target data in an area indicated by the TAZ grid identified by the grid code.

In a possible implementation, there are a plurality of pieces of target data, and different pieces of target data are from different platforms.

According to a third aspect, this application provides a device, including: at least one memory, configured to store a program; and at least one processor, configured to execute the program stored in the memory. When the program stored in the memory is executed, the processor is configured to perform the method described in any one of the first aspect or the possible implementations of the first aspect.

According to a fourth aspect, this application provides a computer-readable storage medium, where the computer-readable storage medium stores a computer program. When the computer program is run on a processor, the processor is enabled to perform the method described in any one of the first aspect or the possible implementations of the first aspect.

According to a fifth aspect, this application provides a computer program product. When the computer program product is run on a processor, the processor is enabled to perform the method described in any one of the first aspect or the possible implementations of the first aspect.

It may be understood that, for beneficial effects of the second aspect to the fifth aspect, refer to related descriptions in the first aspect. Details are not described herein again.

### BRIEF DESCRIPTION OF DRAWINGS

The following briefly describes the accompanying drawings used in descriptions of embodiments or the conventional technology.
FIG. 1 is a diagram of an architecture of a TAZ grid data service system according to an embodiment of this application;
FIG. 2 is a schematic flowchart of a TAZ grid data service method according to an embodiment of this application;
FIG. 3 is a diagram of a TAZ grid according to an embodiment of this application;
FIG. 4 is a diagram of a TAZ grid according to an embodiment of this application;
FIG. 5 is a diagram of eight neighborhoods according to an embodiment of this application;
FIG. 6 is a schematic flowchart of a grid coding method according to an embodiment of this application; and
FIG. 7 is a diagram of a structure of a grid coding apparatus according to an embodiment of this application.

### DESCRIPTION OF EMBODIMENTS

The term "and/or" in this specification describes an association relationship between associated objects and represents that three relationships may exist. For example, A and/or B may represent the following three cases: Only A exists, both A and B exist, and only B exists. The character "/" in this specification indicates an "or" relationship between the associated objects. For example, A/B represents A or B.

In the specification and claims of this application, the terms "first", "second", and the like are intended to distinguish between different objects, but do not indicate a particular order of the objects. For example, a first response message, a second response message, and the like are used to distinguish between different response messages, but do not indicate a particular order of the response messages.

In embodiments of this application, the terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the term "example", "for example", or the like is intended to present a related concept in a specific manner.

In the descriptions of embodiments of this application, unless otherwise specified, "a plurality of" means two or more. For example, a plurality of processing units means two or more processing units, and a plurality of elements means two or more elements.

Generally, in a direction of operation and management of a grid obtained through division based on a TAZ, for a new scenario of an autonomous network, service data generated by an operations support system (operations support system, OSS) (referred to as an "O domain system" below), a business support system (business support system, BSS) (referred to as a B domain system below), and a third-party data system (referred to as an S domain system below) tends to be jointly analyzed in the industry. Currently, an effective method is to map multi-domain data indicators to a grid obtained through division based on the TAZ (referred to as a "TAZ grid" below), to form a TAZ grid with multi-domain data fused, perform corresponding data mining based on a unified grid space to generate a corresponding service feature, and formulate a corresponding TAZ grid autonomy objective based on the service feature. To reduce transfer of invalid data, data may be first processed on the O domain, B domain, and S domain platforms, and then separately mapped to the TAZ grid. The data is uploaded to a fused big data analysis platform for joint analysis of multi-domain data. An analysis result of the fused big data analysis platform may be opened to an ecosystem partner big data analysis platform based on the TAZ grid. However, because the grid obtained through division based on the TAZ is usually an irregular graph, it is difficult to mark the TAZ grid, and consequently, it is difficult to map all the data in the O domain, B domain, and S domain systems to the TAZ grid. As a result, it is difficult to implement cross-system data exchange.

In view of this, according to a TAZ grid coding method provided in embodiments of this application, a unique spatial flag can be established for each TAZ grid, and a boundary and an attribute of each TAZ grid can be coded, to perform efficient spatial query and cross-system information exchange. This resolves a problem that an existing coding rule cannot express a boundary and an attribute of a TAZ, and can hardly be applied to large-scale cross-system exchange.

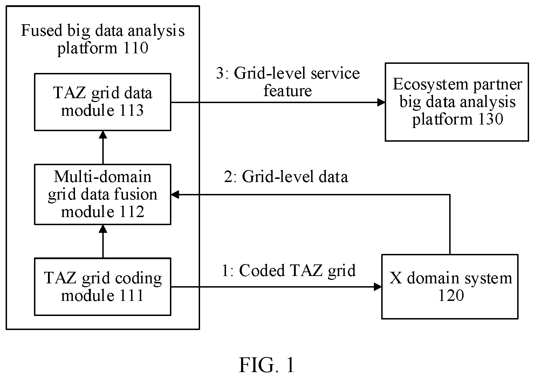

For example, FIG. 1 shows an architecture of a TAZ grid data service system. As shown in FIG. 1, the system may include a fused big data analysis platform 110, an X domain system 120, and an ecosystem partner big data analysis platform 130.

The fused big data analysis platform 110 may include a TAZ grid coding module 111, a multi-domain grid data fusion module 112, and a TAZ grid data module 113. The TAZ grid coding module 111 is mainly configured to provide a TAZ grid coding service, to establish a unique spatial flag for each TAZ grid, and code a boundary and an attribute of each TAZ grid. The multi-domain grid data fusion module 112 is mainly configured to fuse grid-level data in different domains in a grid coded based on the TAZ. The TAZ grid data module 113 is mainly configured to generate, based on multi-domain service data fused by the multi-domain grid data fusion module 112, feature data required by the industry.

The X domain system 120 mainly includes at least one of an O domain system, a B domain system, and an S domain system. The X domain system 120 may receive a TAZ grid code obtained through coding by the TAZ grid coding module 111, and further code service data specific to the X domain system 120 and map coded service data to the TAZ grid code, to obtain grid-level data. In addition, the X domain system 120 may upload the obtained grid-level data to the multi-domain grid data fusion module 112, so that the multi-domain grid data fusion module 112 fuses the grid-level data uploaded by the plurality of different domain systems.

The ecosystem partner big data analysis platform 130 is mainly configured to obtain, by using the feature data output by the TAZ grid data module 113 and service data of the industry, an analysis report that meets an industry requirement.

In some embodiments, a TAZ software development kit (software development kit, SDK) may be configured in each of the fused big data analysis platform 110, the X domain system 120, and the ecosystem partner big data analysis platform 130. The TAZ SDK is used to provide TAZ grid-based coding and decoding functions for each platform.

The following describes, based on the system described in FIG. 1, a TAZ grid-based data service method provided in an embodiment of this application.

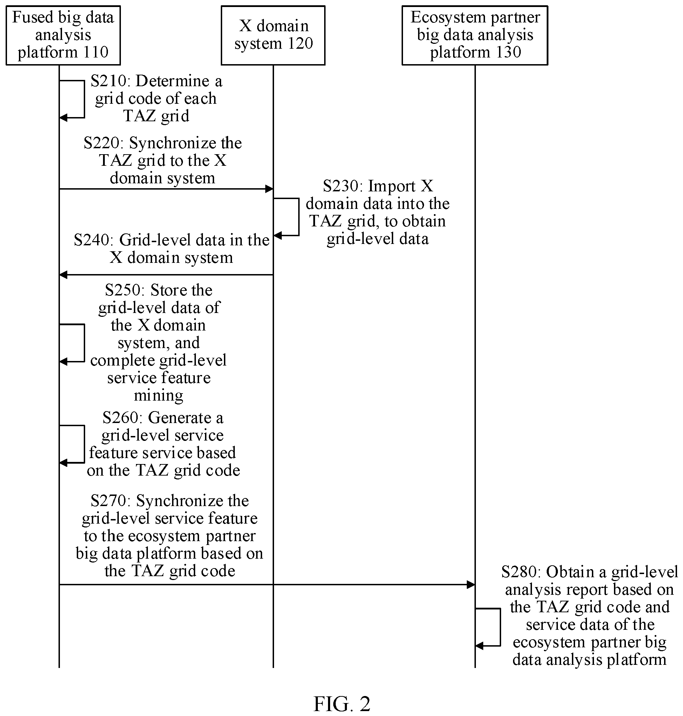

For example, FIG. 2 shows a procedure of a TAZ grid data service method. The method mainly relates to the fused big data analysis platform 110, the X domain system 120, and the ecosystem partner big data analysis platform 130 described in FIG. 1. As shown in FIG. 2, the method may include the following steps.

S210: The fused big data analysis platform 110 determines a grid code of each TAZ grid.

In this embodiment, the fused big data analysis platform 110 may first divide geographic information system (geographic information system, GIS) data into TAZ grids based on data such as an existing road network and a POI. Each TAZ grid is then coded, to obtain the grid code of each TAZ grid. For example, the fused big data analysis platform 110 may further directly obtain the TAZ grid, spatial information of each TAZ grid, and the like.

In this embodiment, the grid code of each TAZ grid may include: a level code, a key code, a bounding code, a compression code, a boundary chaincode, and an attribute code.

The level code represents a level of the TAZ grid in geographical coordinate subdividing grid with one-dimensional integer coding on 2n-tree (geographical coordinate subdividing grid with one-dimension integer coding on 2ⁿ-tree, GeoSOT). For example, when a minimum level of the TAZ grid in the GeoSOT is 18, it may be determined that the level code is 18.

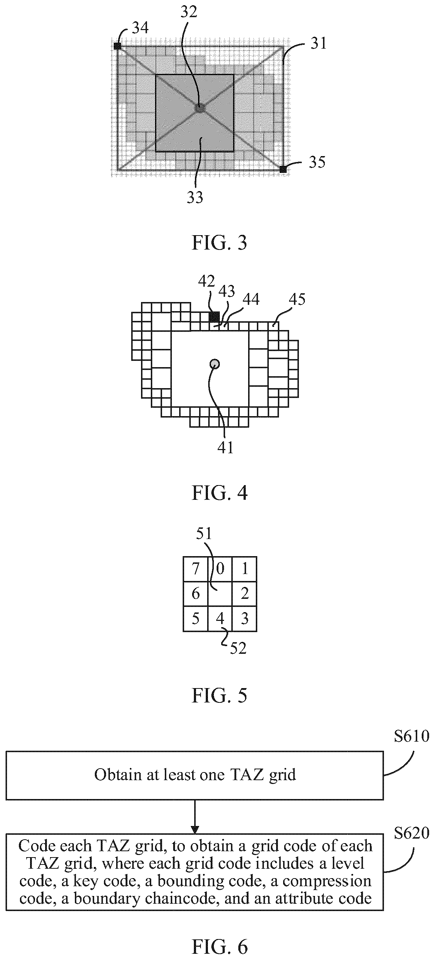

The key code represents a subgrid that is inside the TAZ grid and that includes a centroid obtained based on a minimum bounding rectangle of the TAZ grid. For example, as shown in FIG. 3, a graph included in a rectangular box 31 is a TAZ grid, and the TAZ grid may include at least one subgrid. In FIG. 3, the rectangular box 31 is a bounding rectangle of the TAZ grid, and a point 32 is a centroid of the bounding rectangle. A subgrid 33 in the TAZ grid is a subgrid including the point 32. Each subgrid in the TAZ grid may have a grid code, and each grid code may identify a subgrid. The key code may be a grid code of the subgrid including the centroid. For example, when the grid code of the subgrid including the centroid is 157341, the key code may be, but is not limited to, 157341. For example, the grid code of each subgrid in the TAZ grid may be a code of each subgrid at a specific level in the GeoSOT, for example, a code at a minimum level.

The bounding code represents the minimum bounding rectangle of the TAZ grid. A minimum bounding rectangle of each TAZ grid may be calculated based on an original boundary of the TAZ grid. For example, still refer to FIG. 3. The rectangular box 31 may be the minimum bounding rectangle of the TAZ grid. For a rectangle, after locations of two diagonal points of the rectangle are obtained, a location of the rectangle can be determined. Therefore, locations of two diagonal points of the minimum bounding rectangle of the TAZ grid may be selected to identify the bounding rectangle. Still refer to FIG. 3. A corner point 34 in a northwest direction and a corner point 35 in a southeast direction of the rectangular box 31 may be selected to identify the rectangular box 31. Locations of the corner point 34 and the corner point 35 at a specific level in the GeoSOT may be used as respective locations of the two corner points. For example, locations of the corner point 34 and the corner point 35 at a 21^{st} level in the GeoSOT may be used as required locations, and the locations of the corner point 34 and the corner point 35 are converted into decimal GeoSOT grid codes. A Morton code cross operation is then performed on the locations of the two corner points, to obtain a bounding code. For example, when the location of the corner point 34 is 1382065, and the location of the corner point 35 is 043287, the bounding code obtained through the Morton code cross operation is 1034832208675.

The compression code represents a compression level set by a user for an original chaincode. The original chaincode may be understood as a code of a grid chain formed by all subgrids on an outermost side of the TAZ grid.

For the original chaincode, the centroid of the minimum bounding rectangle of the TAZ grid may be used as a reference, and a subgrid that is located in the TAZ grid and in a direction (for example, a due north direction) of the centroid, and that is farthest from the centroid is used as a start grid of the grid chain corresponding to the TAZ grid. A direction of the grid chain is then selected, for example, a clockwise direction or a counterclockwise direction. An adjacent location relationship between the subgrids on the outermost side of the TAZ grid may be recorded based on the selected direction of the grid chain and the start grid by using an eight-neighborhood algorithm. Finally, the original chaincode can be determined based on a grid code of the start grid and the recorded adjacent location relationship between the subgrids.

For example, as shown in FIG. 4, in a TAZ grid, a subgrid 42 in a due north direction of a centroid 41 may be selected as a start grid, and a clockwise direction may be selected as a direction of a grid chain of the TAZ grid. It can be determined by using the eight-neighborhood algorithm that a location relationship of a subgrid 43 relative to the subgrid 42 is 4, and a location relationship of a subgrid 44 relative to the subgrid 43 is 2. After subgrids around the TAZ grid are traversed, relative location relationship between the subgrids can be obtained. Further, if the subgrid 42 is a grid at the 21^{st} level in the GeoSOT, and a grid code is 1258729, an original chaincode is 1258729/4222...322. For the eight-neighborhood algorithm, determining the location relationship between the subgrid 43 and the subgrid 42 is used as an example. As shown in FIG. 5, a blank area 51 may be placed at the subgrid 42 in FIG. 4, and then a location of the subgrid 43 is observed. In this case, the subgrid 43 is located in an area 52 shown in FIG. 5, and a number at an area 53 is 4. Therefore, the location of the subgrid 43 relative to the subgrid 42 is 4.

The boundary chaincode represents a boundary obtained by optimizing a boundary of the TAZ grid. The boundary chaincode may be determined based on the original chaincode and the compression code. In some embodiments, a value of the compression code may represent a quantity of subgrids reserved around the TAZ grid. For example, when the compression code is 9, it represents that nine subgrids are reserved around the TAZ grid. After the compression code is determined, subgrids having a quantity the same as the value of the compression code may be extracted, by maintaining a shape of the TAZ grid as a reference, from the original chaincode as required subgrids, and these subgrids need to include the start grid in the original chaincode. In this way, a complex boundary is simplified into a simple boundary based on a geometric thinning algorithm. Generally, a thinning order follows that shorter edges are first merged. Because an adjacency relationship between the extracted subgrids has been damaged, a relative location relationship between these subgrids may be re-determined. During determining of a relative location relationship between subgrids, a previous subgrid may be used as a reference, to determine a relative location relationship between the subgrid and a next subgrid. For example, still refer to FIG. 4. If the extracted subgrids include the subgrid 41 and a subgrid 45, a coordinate system may be established by using the subgrid 41 as a coordinate origin. A quantity of subgrids between the two subgrids in an x direction is then determined. In this case, it can be determined that there are six subgrids between the two subgrids, and the six subgrids are in a positive direction of an x axis in the coordinate system. A quantity of subgrids between the two subgrids in a y direction can be determined. In this case, it can be determined that there is one subgrid between the two subgrids, and the subgrid is in a negative direction of a y axis in the coordinate system. Therefore, it can be determined that a location relationship of the subgrid 45 relative to the subgrid 43 is (+6_-1). In this way, after the extracted subgrids are traversed, the relative location relationship between the extracted subgrids can be obtained, and then the boundary chaincode can be obtained. For example, it is assumed that the relative location relationship between the extracted subgrids is 12587291+6_-1/+2_-2/0_-5/-5_-3/-5_0/-5_+3/-1_+7/+1_+1/+7_-1. In the relative location relationship, a line segment is represented between two adjacent "/"; and "+/-" represents a place holder and indicates a direction of a next boundary grid relative to a current grid, which is the same as that in a Cartesian coordinate system where + indicates an upper right direction, and - indicates a lower left direction. The boundary chaincode can be obtained by deleting "/" and "_" in the location relationship. The boundary chaincode is 12587291+6-1+2-20-5-5-3-50-5+3-1+7+1+1+7-1.

The attribute code represents a service scenario of an area in which the TAZ grid is located. The attribute code may be obtained by querying a preset mapping relationship between categories and category code numbers based on a category of the area in which the TAZ grid is located, and determining a category code number associated with the category of the area in which the TAZ grid is located, where the category code number is used as the attribute code. For example, if the category of the area in which the TAZ grid is located is real estate, and a category code number associated with the real estate is 11, the attribute code is 11.

In some embodiments, after a level code, a key code, a bounding code, a compression code, a boundary chaincode, and an attribute code that correspond to a TAZ grid are merged, a grid code of the TAZ grid can be obtained. The level code, the key code, the bounding code, the compression code, the boundary chaincode, and the attribute code may be separated by "#". For example, if the level code is 18, the key code is 157341, the bounding code is 1034832208675, the compression code is 9, the boundary chaincode is 1258729/+6-1+2-20-5-5-3-50-5+3-1+7+1+1+7-1, and the attribute code is 11, the grid code is 18#157341#1034832208675#9#12587291+6-1+2-20-5-5-3-50-5+3-1+7+1+1+7-1#11.

S220: The fused big data analysis platform 110 synchronizes the TAZ grid to the X domain system 120.

In this embodiment, after the grid code of each TAZ grid is determined, the fused big data analysis platform 110 synchronizes the TAZ grid to the X domain system 120.

S230: The X domain system 120 imports data in the X domain system 120 into the TAZ grid, to obtain grid-level data.

In this embodiment, the X domain system 120 may collect corresponding data into different TAZ grids based on grid codes of TAZ grids corresponding to base station-level data, cell-level data, and grid-level data. Because each TAZ grid may represent an area, data in the area represented by the TAZ grid may be collected into the TAZ grid. The X domain system 120 may be an O domain system, a B domain system, or an S domain system. The O domain system is responsible for storing and retrieving O domain telecom data, including traffic statistics, MRs, engineering parameters, delay, traffic, rates, and the like. The B domain system is responsible for storing and processing B domain operation data, including user information, market, channels, complaints, costs, information, and the like. The S domain system is responsible for organizing, storing, managing, and retrieving third-party S domain data, including geographical data, people flow data, population profiles, and the like.

In addition, the X domain system 120 may further determine a service of an area in which each TAZ grid is located, obtain a service code based on the determined service, and add the service code to a grid code of the TAZ grid. For example, a format of the service code may be: service name 1=service value 1, service name 2=service value 2, ..., service name X=service value Y.

S240: The X domain system 120 uploads the grid-level data to the fused big data analysis platform 110.

S250: The fused big data analysis platform 110 uniformly stores the grid-level data of the X domain system based on the TAZ grid code, and completes grid-level service feature mining.

In this embodiment, the fused big data analysis platform 110 may traverse TAZ grid data reported by all domains, and store, in a same TAZ grid, service data corresponding to a same grid code (except a service code), to store service data in different domains in the same TAZ grid. Service data included in the service code in the same grid code may be extracted, to complete the grid-level service feature mining.

S260: The fused big data analysis platform 110 generates a grid-level service feature service based on the TAZ grid code.

In this embodiment, the fused big data analysis platform 110 may perform fused analysis on service data in different domains, generate feature data required by different industries, and add the feature data as a service code to the grid code of the TAZ grid.

S270: The fused big data analysis platform 110 synchronizes the grid-level service feature to the big data analysis platform 130 of an ecosystem partner based on the TAZ grid code.

S280: The ecosystem partner big data analysis platform 130 obtains a grid-level analysis report based on the TAZ grid code and service data of the ecosystem partner big data analysis platform 130.

In this embodiment, the ecosystem partner big data analysis platform 130 may compare service data of the ecosystem partner big data analysis platform 130 with the service data included in the grid code of the TAZ grid, to obtain the corresponding grid-level analysis report.

In this way, TAZ grid division of different platforms is completely consistent, and grid codes of TAZ grids are fixed and unified. In other words, each TAZ grid has a unique spatial flag. Therefore, efficient spatial query and cross-system information exchange can be performed, and a problem that an existing coding rule cannot express a boundary and an attribute of a TAZ, and can hardly be applied to large-scale cross-system exchange is resolved. In addition, the grid code of the TAZ grid is used as an index field, and the index field is in one-to-one mapping relationship with geographical space, and grids completely overlap, without adaptation cost, and without loss in precision and efficiency.

The following describes, based on the foregoing content, a grid coding method provided in an embodiment of this application.

For example, FIG. 6 shows a grid coding method. It may be understood that the method may be performed by any apparatus, device, platform, or device cluster that has computing and processing capabilities. As shown in FIG. 6, the grid coding method may include the following steps.

S610: Obtain at least one TAZ grid.

In this embodiment, after an operator or another user obtains TAZ grids through division, the user may upload the TAZ grids, to obtain at least one TAZ grid. In addition, at least one TAZ grid may be automatically obtained from a network. For example, the TAZ grid may be an irregular graph.

S620: Code each TAZ grid, to obtain a grid code of each TAZ grid, where each grid code includes a level code, a key code, a bounding code, a compression code, a boundary chaincode, and an attribute code.

In this embodiment, after the TAZ grid is obtained, each TAZ grid may be coded, to obtain the grid code of each TAZ grid. Each grid code includes a level code, a key code, a bounding code, a compression code, a boundary chaincode, and an attribute code.

The level code may represent a level of the TAZ grid in GeoSOT. For example, the level code may be the same as a value of the level of the TAZ grid in the GeoSOT. In this way, a mapping relationship between the TAZ grid and a grid in the GeoSOT can be established by using the level code.

The key code may represent a subgrid that is inside the TAZ grid and that includes a centroid obtained based on a minimum bounding rectangle of the TAZ grid. For example, the key code may be a grid code of a first subgrid in the GeoSOT, and the first subgrid is a subgrid that is inside the TAZ grid and that includes the centroid obtained based on the minimum bounding rectangle of the TAZ grid. For example, the first subgrid may be the subgrid 33 shown in FIG. 3. In this way, a location of the centroid of the TAZ grid in the GeoSOT can be obtained by querying the GeoSOT by using the key code.

The bounding code may represent the minimum bounding rectangle of the TAZ grid. For example, the bounding code may be obtained based on locations of two endpoints of any diagonal of the bounding rectangle. For example, still refer to FIG. 3. The bounding code may be obtained based on the locations of the corner point 34 and the corner point 35. In this way, the location of the TAZ grid in the GeoSOT can be obtained by querying the GeoSOT by using the bounding code.

The compression code may represent a compression level set by a user for an original chaincode. For example, the compression code may be set by the user, or may be a default value. The original chaincode is a code of a grid chain formed by all subgrids outside the TAZ grid.

The boundary chaincode may represent a boundary obtained by optimizing a boundary of the TAZ grid. For example, the boundary chaincode may be obtained based on the compression code and the original chaincode. For example, second subgrids having a quantity the same as a value of the compression code may be first extracted, with an objective of maintaining a shape of the TAZ grid, from all the subgrids outside the TAZ grid, where at least one of the second subgrids is in a first direction (for example, a due north direction or a due west direction) of the centroid of the bounding rectangle. A relative location relationship between the second subgrids is then determined based on the original chaincode. Finally, the boundary chaincode is obtained based on the relative location relationship between the second subgrids. For a specific process, refer to the manner of determining the boundary chaincode in S210. Details are not described herein again. In this way, the original chaincode is compressed by using the compression code, to reduce subsequent query workload and improve efficiency.

The attribute code may represent a service scenario of an area in which the TAZ grid is located. For example, the attribute code may be obtained by querying a preset mapping relationship between categories and category code numbers based on a category of the area in which the TAZ grid is located. The attribute code may be a category code number associated with the category of the area in which the TAZ grid is located. In this way, the service scenario of the area in which the TAZ grid is located can be obtained by using the attribute code.

For a manner of determining the level code, the key code, the bounding code, the compression code, the boundary chaincode, and the attribute code in each grid code, refer to related descriptions of S210 in FIG. 2. Details are not described herein again.

In this way, after the TAZ grid is obtained, each TAZ grid may be coded, to obtain a unique spatial flag of the TAZ grid, so that data of different systems can be mapped to the TAZ grid, thereby reducing difficulty in cross-system data exchange.

In some embodiments, each grid code further includes a service code. The service code may represent target data in an area indicated by the TAZ grid identified by the grid code. In this way, data in the area indicated by the TAZ grid can be mapped to the TAZ grid. In some embodiments, there are a plurality of pieces of target data, and different pieces of target data are from different platforms. In this way, data generated by different platforms in the area indicated by the TAZ grid can be mapped to the same TAZ grid, implementing cross-system data exchange. For example, the different platforms may include an O domain system, a B domain system, an S domain system, and the like.

It may be understood that sequence numbers of the steps do not mean execution sequences in the foregoing embodiments. The execution sequences of the processes should be determined based on functions and internal logic of the processes, and should not be construed as any limitation on the implementation processes of embodiments of this application. In addition, in some possible implementations, the steps in the foregoing embodiments may be selectively performed, may be partially performed, or may be all performed based on an actual situation. This is not limited herein. In addition, provided that no conflict exists, all or some of any features in the foregoing embodiments may be freely and randomly combined. A combined technical solution also falls within the scope of this application.

Based on the method in the foregoing embodiments, an embodiment of this application provides a grid coding apparatus.

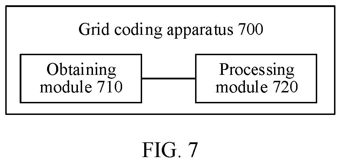

For example, FIG. 7 shows a structure of a grid coding apparatus. As shown in FIG. 7, the grid coding apparatus 700 includes: an obtaining module 710 and a processing module 720. The obtaining module 710 is configured to obtain at least one traffic autonomous zone (TAZ) grid. The processing module 720 is configured to code each TAZ grid, to obtain a grid code of each TAZ grid, where each grid code includes a level code, a key code, a bounding code, a compression code, a boundary chaincode, and an attribute code. The level code represents a level of the TAZ grid in geographical coordinate subdividing grid with one-dimensional integer coding on 2n-tree (GeoSOT). The key code represents a subgrid that is inside the TAZ grid and that includes a centroid obtained based on a minimum bounding rectangle of the TAZ grid. The bounding code represents the minimum bounding rectangle of the TAZ grid. The compression code represents a compression level set by a user for an original chaincode, and the original chaincode is a code of a grid chain formed by all subgrids outside the TAZ grid. The boundary chaincode represents a boundary obtained by optimizing a boundary of the TAZ grid. The attribute code represents a service scenario of an area in which the TAZ grid is located.

In some embodiments, the level code is the same as a value of the level of the TAZ grid in the GeoSOT.

In some embodiments, the key code is a grid code of a first subgrid in the GeoSOT, and the first subgrid is a subgrid that is inside the TAZ grid and that includes the centroid obtained based on the minimum bounding rectangle of the TAZ grid.

In some embodiments, the bounding code is obtained based on locations of two endpoints of any diagonal of the bounding rectangle.

**In** some embodiments, the boundary chaincode is obtained based on the compression code and the original chaincode.

Further, the processing module 720 is specifically configured to: extract, with an objective of maintaining a shape of the TAZ grid, second subgrids having a quantity the same as a value of the compression code from all the subgrids outside the TAZ grid, where at least one of the second subgrids is in a first direction of the centroid of the bounding rectangle; determine a relative location relationship between the second subgrids based on the original chaincode; and obtain the boundary chaincode based on the relative location relationship between the second subgrids.

**In** some embodiments, the attribute code is obtained by querying a preset mapping relationship between categories and category code numbers based on a category of the area in which the TAZ grid is located. The attribute code is a category code number associated with the category of the area in which the TAZ grid is located.

In some embodiments, each grid code further includes a service code. The service code may represent target data in an area indicated by the TAZ grid identified by the grid code.

In some embodiments, there are a plurality of pieces of target data, and different pieces of target data are from different platforms.

It should be understood that the foregoing apparatus is configured to perform the method in the foregoing embodiments. An implementation principle and technical effect of a corresponding program module in the apparatus are similar to those described in the foregoing method. For a working process of the apparatus, refer to a corresponding process in the foregoing method. Details are not described herein again.

According to the method in the foregoing embodiments, an embodiment of this application provides a device. The device may include: at least one memory configured to store a program and at least one processor configured to execute the program stored in the memory. When the program stored in the memory is executed, the processor is configured to perform the method described in the foregoing embodiments.

According to the method in the foregoing embodiments, an embodiment of this application provides a computer-readable storage medium. The computer-readable storage medium stores a computer program. When the computer program is run on a processor, the processor is enabled to perform the method in the foregoing embodiments.

According to the method in the foregoing embodiments, an embodiment of this application provides a computer program product. When the computer program product is run on a processor, the processor is enabled to perform the method in the foregoing embodiments.

It may be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA), or another programmable logic device, a transistor logic device, a hardware component, or any combination thereof. The general-purpose processor may be a microprocessor or any regular processor or the like.

The method steps in embodiments of this application may be implemented in a hardware manner, or may be implemented in a manner of executing software instructions by the processor. The software instructions may include corresponding software modules. The software modules may be stored in a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may alternatively be a component of the processor. The processor and the storage medium may be disposed in an ASIC.

All or some of the foregoing embodiments may be implemented by using software, hardware, firmware, or any combination thereof. When software is used to implement the foregoing embodiments, all or a part of the foregoing embodiments may be implemented in a form of a computer program product. The computer program product includes one or more computer instructions. When the computer instructions are loaded and executed on a computer, the procedure or functions according to embodiments of this application are all or partially generated. The computer may be a general-purpose computer, a dedicated computer, a computer network, or other programmable apparatuses. The computer instructions may be stored in a computer-readable storage medium, or may be transmitted by using the computer-readable storage medium. The computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk (solid-state disk, SSD)), or the like.

It may be understood that various numbers in embodiments of this application are merely used for differentiation for ease of description, and are not used to limit the scope of embodiments of this application.

## Claims

1. A grid coding method, wherein the method comprises:
obtaining at least one traffic autonomous zone (TAZ) grid; and
coding each TAZ grid, to obtain a grid code of each TAZ grid, wherein each grid code comprises a level code, a key code, a bounding code, a compression code, a boundary chaincode, and an attribute code, wherein
the level code represents a level of the TAZ grid in geographical coordinate subdividing grid with one-dimensional integer coding on 2n-tree (GeoSOT); the key code represents a subgrid that is inside the TAZ grid and that comprises a centroid obtained based on a minimum bounding rectangle of the TAZ grid; the bounding code represents the minimum bounding rectangle of the TAZ grid; the compression code represents a compression level set by a user for an original chaincode, and the original chaincode is a code of a grid chain formed by all subgrids outside the TAZ grid; the boundary chaincode represents a boundary obtained by optimizing a boundary of the TAZ grid; and the attribute code represents a service scenario of an area in which the TAZ grid is located.

2. The method according to claim 1, wherein the level code is the same as a value of the level of the TAZ grid in the GeoSOT.

3. The method according to claim 1 or 2, wherein the key code is a grid code of a first subgrid in the GeoSOT, and the first subgrid is a subgrid that is inside the TAZ grid and that comprises the centroid obtained based on the minimum bounding rectangle of the TAZ grid.

4. The method according to any one of claims 1 to 3, wherein the bounding code is obtained based on locations of two endpoints of any diagonal of the bounding rectangle.

5. The method according to any one of claims 1 to 4, wherein the boundary chaincode is obtained based on the compression code and the original chaincode.

6. The method according to claim 5, wherein obtaining the boundary chaincode based on the compression code and the original chaincode specifically comprises:
extracting, with an objective of maintaining a shape of the TAZ grid, second subgrids having a quantity the same as a value of the compression code from all the subgrids outside the TAZ grid, wherein at least one of the second subgrids is in a first direction of the centroid of the bounding rectangle;
determining a relative location relationship between the second subgrids based on the original chaincode; and
obtaining the boundary chaincode based on the relative location relationship between the second subgrids.

7. The method according to any one of claims 1 to 6, wherein the attribute code is obtained by querying a preset mapping relationship between categories and category code numbers based on a category of the area in which the TAZ grid is located, wherein the attribute code is a category code number associated with the category of the area in which the TAZ grid is located.

8. The method according to any one of claims 1 to 7, wherein each grid code further comprises a service code, and the service code represents target data in an area indicated by the TAZ grid identified by the grid code.

9. The method according to claim 8, wherein there are a plurality of pieces of target data, and different pieces of target data are from different platforms.

10. A grid coding apparatus, wherein the apparatus comprises:
an obtaining module, configured to obtain at least one traffic autonomous zone (TAZ) grid; and
a processing module, configured to code each TAZ grid, to obtain a grid code of each TAZ grid, wherein each grid code comprises a level code, a key code, a bounding code, a compression code, a boundary chaincode, and an attribute code, wherein
the level code represents a level of the TAZ grid in geographical coordinate subdividing grid with one-dimensional integer coding on 2n-tree (GeoSOT); the key code represents a subgrid that is inside the TAZ grid and that comprises a centroid obtained based on a minimum bounding rectangle of the TAZ grid; the bounding code represents the minimum bounding rectangle of the TAZ grid; the compression code represents a compression level set by a user for an original chaincode, and the original chaincode is a code of a grid chain formed by all subgrids outside the TAZ grid; the boundary chaincode represents a boundary obtained by optimizing a boundary of the TAZ grid; and the attribute code represents a service scenario of an area in which the TAZ grid is located.

11. The apparatus according to claim 10, wherein the level code is the same as a value of the level of the TAZ grid in the GeoSOT.

12. The apparatus according to claim 10 or 11, wherein the key code is a grid code of a first subgrid in the GeoSOT, and the first subgrid is a subgrid that is inside the TAZ grid and that comprises the centroid obtained based on the minimum bounding rectangle of the TAZ grid.

13. The apparatus according to any one of claims 10 to 12, wherein the bounding code is obtained based on locations of two endpoints of any diagonal of the bounding rectangle.

14. The apparatus according to any one of claims 10 to 13, wherein the boundary chaincode is obtained based on the compression code and the original chaincode.

15. The apparatus according to claim 14, wherein the processing module is specifically configured to:
extract, with an objective of maintaining a shape of the TAZ grid, second subgrids having a quantity the same as a value of the compression code from all the subgrids outside the TAZ grid, wherein at least one of the second subgrids is in a first direction of the centroid of the bounding rectangle;
determine a relative location relationship between the second subgrids based on the original chaincode; and
obtain the boundary chaincode based on the relative location relationship between the second subgrids.

16. The apparatus according to any one of claims 10 to 15, wherein the attribute code is obtained by querying a preset mapping relationship between categories and category code numbers based on a category of the area in which the TAZ grid is located, wherein the attribute code is a category code number associated with the category of the area in which the TAZ grid is located.

17. The apparatus according to any one of claims 10 to 16, wherein each grid code further comprises a service code, and the service code represents target data in an area indicated by the TAZ grid identified by the grid code.

18. The apparatus according to claim 17, wherein there are a plurality of pieces of target data, and different pieces of target data are from different platforms.

19. A device, comprising:
at least one memory, configured to store a program; and
at least one processor, configured to execute the program stored in the memory, wherein when the program stored in the memory is executed, the processor is configured to perform the method according to any one of claims 1 to 9.

20. A computer-readable storage medium, wherein the computer-readable storage medium stores a computer program, and when the computer program is run on a processor, the processor is enabled to perform the method according to any one of claims 1 to 9.

21. A computer program product, wherein when the computer program product is run on a processor, the processor is enabled to perform the method according to any one of claims 1 to 9.
